(19) Europäisches Patentamt

European Patent Office

Office européen des brevets

(11) **EP 1 091 255 A2**

(12) **EUROPEAN PATENT APPLICATION**

(43) Date of publication:
**11.04.2001 Bulletin 2001/15**

(51) Int. Cl.[7]: **G03F 9/00**

(21) Application number: **00121522.7**

(22) Date of filing: **30.09.2000**

(84) Designated Contracting States:
**AT BE CH CY DE DK ES FI FR GB GR IE IT LI LU
MC NL PT SE**
Designated Extension States:
**AL LT LV MK RO SI**

(30) Priority: **04.10.1999 JP 28250699**

(71) Applicant:
**USHIODENKI KABUSHIKI KAISHA
Chiyoda-ku, Tokyo 100-0004 (JP)**

(72) Inventor: **Tanaka, Yoneta
Kanagawa-ken, Yokohama-shi (JP)**

(74) Representative:
**Tomerius, Isabel, Dr. Dipl.-Chem. et al
Patentanwälte Weber & Heim
Bavariaring 29
80336 München (DE)**

(54) **Method of aligning mask and workpiece in exposure device**

(57) A mask and workpiece are aligned with good accuracy even if the shape of workpiece marks, etc., should deform due to process defects by a plurality of workpiece marks (WAM) being affixed in proximity on a workpiece W so as to lie within a field of an alignment microscope, and a plurality of workpiece mark images that are imaged by the alignment microscope are fed to processing unit. The processing unit detects the spatial coordinates of the plurality of workpiece marks and averages their spatial coordinates. Then, a workpiece stage or mask stage is moved so that mask mark has a prescribed spatial relationship with respect to the spatial coordinates determined through the aforementioned averaging, and the mask is aligned with workpiece. Then, the reliability of the spatial coordinates of each of a plurality of workpiece marks is verified and only those workpiece marks which permit the required alignment accuracy to be ensured are be selected.

**EP 1 091 255 A2**

**Description**

**Detailed Description of The Invention**

**Field of Invention**

The present invention concerns a method of aligning a mask and workpiece in which the spatial coordinates of mask alignment marks (hereinafter abbreviated mask marks) formed on a mask and of workpiece alignment marks (hereinafter abbreviated workpiece marks) formed on a workpiece are detected by image processing in an exposure device, after which the mask and workpiece are aligned based on the detected spatial coordinates.

**Description of Related Art**

Exposure devices are used in the process of manufacturing patterns in semiconductor devices, printed circuit boards, liquid-crystal boards, etc., by photolithography. Such an exposure device exposes (transfers) a mask pattern to a workpiece after the mask on which a mask pattern has been formed is aligned with the workpiece and light, including exposure light, is irradiated via the mask.

Examples of exposure devices include a projection exposure device which focuses a mask image on a workpiece via a projection lens, etc., and then exposes a mask pattern on a workpiece, a proximity exposure device which irradiates parallel light on a mask while a slight gap is established between a mask and workpiece and then exposes a mask pattern on a workpiece, and a contact exposure device which irradiates parallel light on a mask while a mask and workpiece are in contact and then exposes a mask pattern on a workpiece.

A mask and workpiece are aligned in the aforementioned exposure device as follows. Mask marks formed on a mask and workpiece marks formed on a workpiece are detected by an alignment microscope. The detection data are subjected to image processing, their spatial coordinates are determined, and the mask or workpiece is moved so that their positions will have a preset spatial relationship.

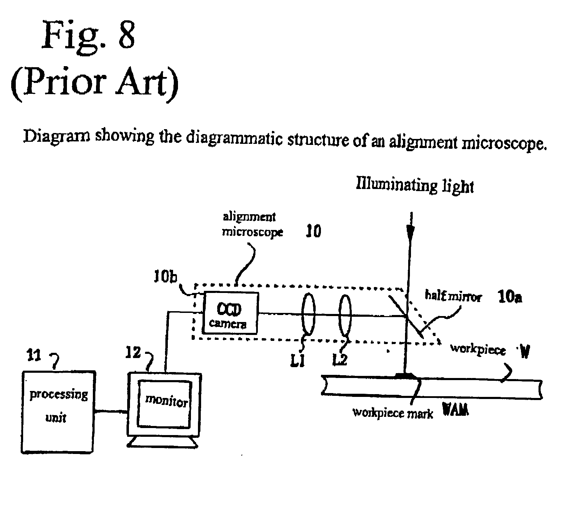

Figure 8 is a diagrammatic view of alignment microscope 10 which detects workpiece marks. Detection of workpiece marks in a proximity exposure device or a contact exposure device as well as the detection of mask marks are carried out in the same manner.

Alignment microscope 10 in Figure 8 comprises a half mirror 10a, lenses L1, L2 and a CCD camera 10b. A processing unit 11 carries out image processing, and is connected to a monitor 12. W denotes a workpiece on which workpiece mark WAM is formed which is detected by conducting of a pattern search as follows:

(1) Registration of workpiece mark

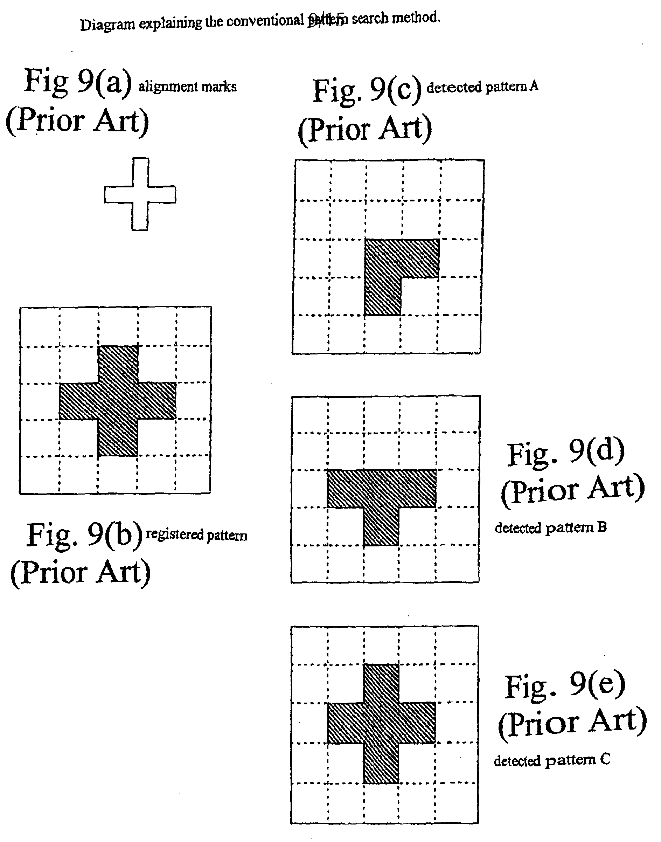

Workpiece mark WAM is registered on processing unit 11. A cruciform mark as shown in Figure 9(a), for example, is used as workpiece mark WAM, and a pattern of workpiece marks in which monitor pixels as the discrete units as shown in Figure 9(b) is registered in processing unit 11. The number of pixels is set at 5 x 5 in said diagram to facilitate the explanation. The registration of aforementioned workpiece mark is explained concretely below.

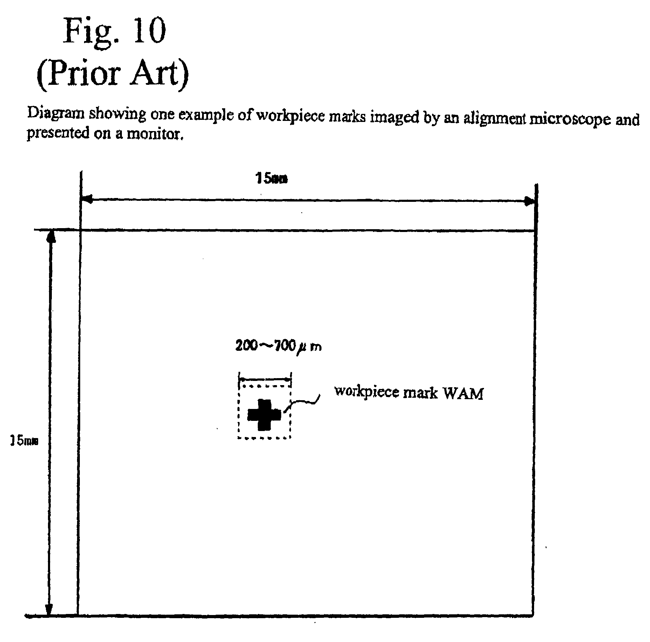

First, the registered workpiece mark WAM is detected by alignment microscope 10 (for example, 3-power magnification). The range at which image processing by processing unit 11 is possible (for example, 15 mm x 15 mm range as shown in Figure 10) is then displayed on monitor 12 following reception by alignment microscope 10.

Next, workpiece mark WAM is enclosed by virtual lines (dotted lines in Figure 10) for workpiece mark registration so as to contain the entire registered workpiece mark WAM. Workpiece mark WAM is then registered in processing unit 11. Processing unit 11 records workpiece mark WAM via the contrast, taking pixels enclosed by aforementioned virtual lines as discrete units. With that, the workpiece mark WAM registration operation is completed.

The size of the workpiece mark varies with the type of workpiece, the user, and the procedures. For example, the size of the virtual lines enclosing workpiece mark WAM would frequently be 200 μm to 700 μm, as shown in Figure 10.

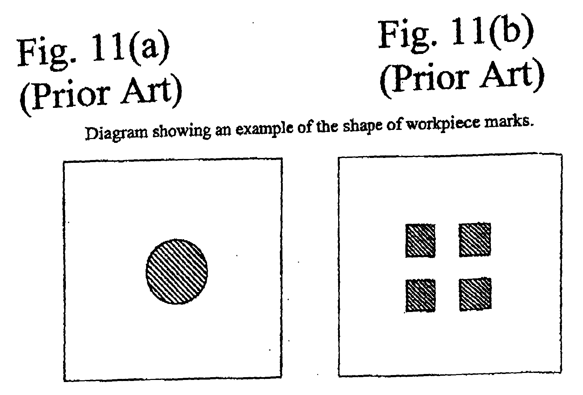

In addition, the shape of the workpiece mark WAM would frequently vary for the same reasons as those noted above. It is not restricted to the cruciform shape shown in Figure 9. The circle shown in Figure 11(a) or the irregular pattern shown in Figure 11(b) that comprises a set may serve as alignment marks. In any event, the registration range is set so as to include all patterns of a workpiece mark.

(2) Pattern search

Workpiece mark WAM on workpiece W is irradiated with illuminating light via half mirror 10a of alignment unit 10, as shown in Figure 8, and workpiece mark WAM is imaged by CCD camera 10b. The image of workpiece mark WAM shown in monitor 12 is input to processing unit 11 and is converted into coordinate data using pixels of monitor 12 as discrete units.

Processing unit 11 compares the aforementioned registered pattern with the image of imaged workpiece mark WAM. For example, the score (correlated value) would be perceived as 60 if the image of the imaged workpiece mark WAM (detected pattern) coincides with 60% of the registered pattern in the case of the detected pattern A shown in Figure 9(c).

Similarly, the score would be perceived as 80 if the image of the imaged workpiece mark WAM (detected pattern) coincides with 80% of the registered pattern in the case of the detected pattern B shown in Figure 9(d). Furthermore, the score would be perceived as 100 if the image of the imaged workpiece mark WAM (detected pattern) coincides with 100% of the registered pattern in the case of the detected pattern C shown in Figure 9(e). As shown above, the entire range shown on the monitor is subjected to a pattern search, and each detected pattern whose score approaches 100 (the highest) is perceived as workpiece mark WAM. Its spatial coordinates are recorded as the spatial coordinates of the workpiece mark.

Aforementioned pattern search is explained concretely below.

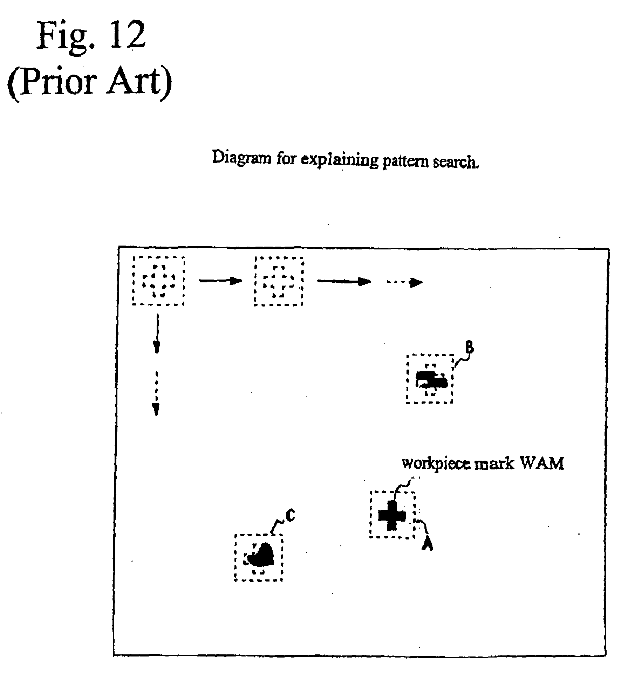

[1] The proximity where workpiece mark WAM is affixed to workpiece W is observed by alignment unit 10, as shown in Figure 12. The same range as that noted above (range 15 mm x 15 mm) is shown.

[2] The registered range surrounded by virtual lines spans the entire area of the range shown by the alignment microscope (range of 15 mm x 15 mm). It is scanned corresponding to each pixel and a score is determined in each layer.

[3] If there is no cause for a contrast to be created outside of the registered workpiece mark, the score would be zero for positions other than position (A) formed by the workpiece mark in Figure 12. However, in regions where image processing is carried out (range of 15 mm x 15 mm), for example, as shown in (B), a pattern is formed outside of the workpiece mark. Furthermore, there are cases in which dirt adheres, as shown in (C). Accordingly, there are cases in which positions having high comparative scores are detected multiple times within the range of image processing.

However, since the position (A) where the registered workpiece mark is found has the highest score, each position which is detected at the highest score is detected as the workpiece mark position, and its spatial coordinates are recorded in processing unit 11. There are various available means of comparing the input pixels with the template pixels which had been prepared in advance and of then assessing the degrees of similarity, as noted above. Optionally, M. Ejiri editor "Controlling industrial application of image processing, First Vol. (Base-System Technology ed.), Jan. 17, 1994, Fuji TechnoSystem K.K., first edition, pp. 26-27, pp. 50-52" may be consulted.

Incidentally, the alignment accuracy is reduced by the following factors in aligning aforementioned marks and workpiece:

(1) The workpiece mark undergoes deformation and spatial deviation due to the following adventitious factors. Causes of deformation and spatial deviation of the workpiece mark are presented below.

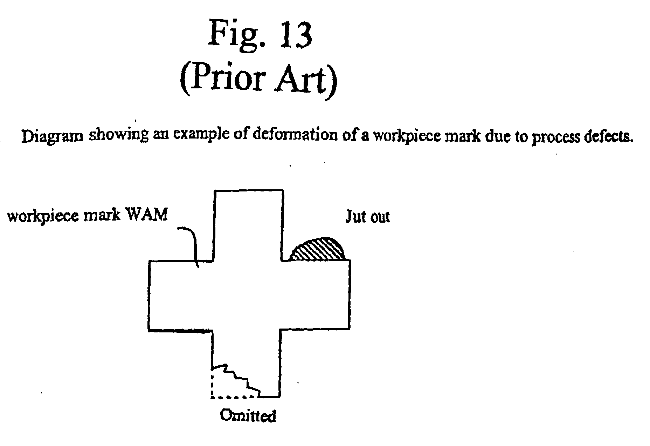

[1] When a workpiece mark is formed by exposure, the alignment mark pattern formed on a mask is transferred to a resist painted on a workpiece and formed by developing just as when a mask pattern is formed on a workpiece. Accordingly, if fine pieces of dirt adhere to part of the mask pattern which is formed, those sections would not be exposed on the workpiece. Thus, in the case of a positive resist in which the exposed section is dissolved in developing fluid, the resist of the section to which dirt adheres after development would remain and the pattern of the workpiece mark would "jut out" as shown in Figure 13. Conversely, that section would be "depressed (omitted)" in the case of a negative resist.

[2] The pattern of the section of a workpiece mark image detected through the alignment unit to which dirt adhered would "jut out" if fine pieces of dirt were to adhere to sections of a workpiece mark on a workpiece.

[3] If a workpiece mark were formed in a pattern of a positive resist, the resist would peel due to the imposition of some form of impact during workpiece conveyance in developing and the workpiece mark would be "omitted". Furthermore, the exposure conditions or developing conditions could change for some reason, leading to overall deformation (pattern collapse) of the workpiece mark pattern. These are generally called "process defects". Deformation of the shape of the workpiece mark pattern often occurs due to "process defects".

The following problems arise due to deformation and spatial deviation of the workpiece mark as indicated above.

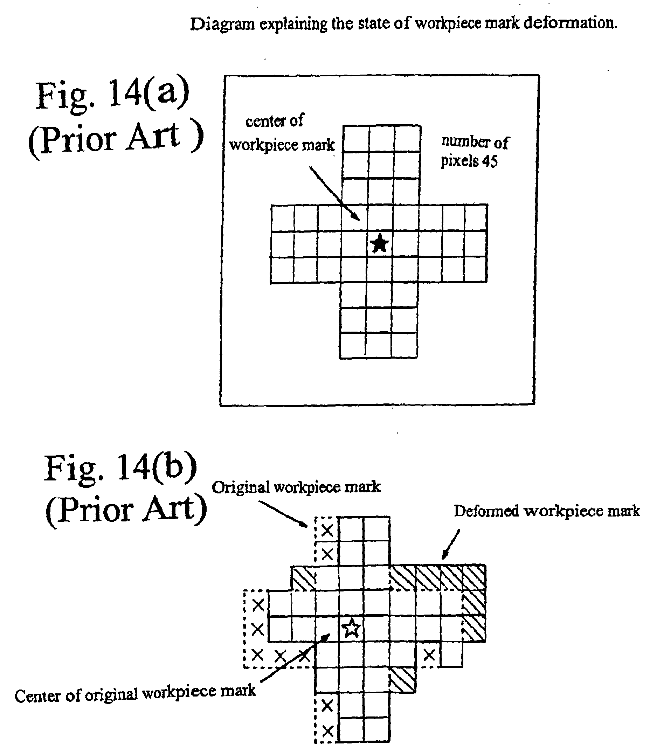

Assume that the registered pattern which is registered in the processing unit is cruciform, as shown in Figure 14(a). In that figure, the squares shown in the cruciform represent individual pixels. In this case, there are 45 pixels that are black. Furthermore, a black star shape is centered in the pattern.

A workpiece mark having the same shape is formed on the workpiece, but the shape is deformed as shown by the thick lines in Figure 14(b) due to process defects. Those sections denoted by "x" are missing while those sections having oblique lines jut out. Furthermore, the dotted lines show the original marks while the white star shows the center of the original workpiece mark.

The aforementioned score would be highest when the black star and the white star coincide if the workpiece mark does not undergo deformation during pattern search, and the position would be detected as the workpiece mark. However, the following occurs if the workpiece mark is deformed as shown in Figure 14(b).

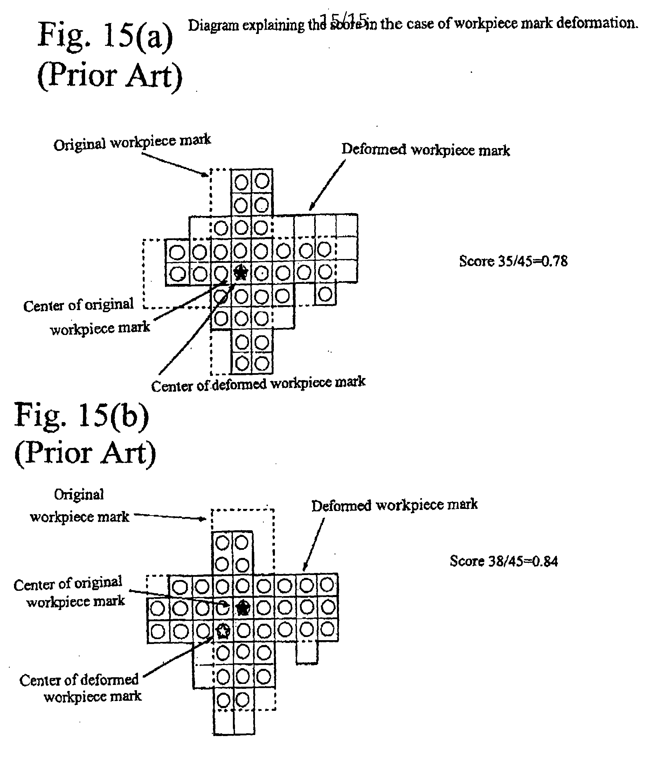

Figure 15(a) shows the state in which the white star and the black star coincide. In this case, 35 of the 45 pixels which should be blackened actually turn black (round pixels in the diagram). Accordingly, the score would be 35/45 = 0.78 (78%). However, if the registered pattern were shifted to the right from the aforementioned position and the state shown in Figure 15(b) were to develop, 38 out of 45 pixels would become black and the score would be 38/45 = 0.84 (84%). Accordingly, the processing unit would recognize this position as the position of the workpiece mark.

In this manner, if the workpiece mark were to become deformed or were to shift in position, the altered position from the original workpiece mark position would be recognized as the position of the workpiece mark. Accordingly, an error would develop to that extent during alignment of the mask and workpiece and the alignment accuracy would deteriorate.

[2] The above applied to workpiece marks, but the same problems arise in the detection of the position of mask marks as well as workpiece marks in proximity exposure devices and contact exposure devices.

A mask and workpiece are proximal when aligning a mask and workpiece in a proximity exposure device or a contact exposure device. For this reason, a pattern on the workpiece below the mask is visible when observing a mask mark by an alignment microscope.

Accordingly, if a workpiece mark is under a mask mark, it is detected by a shape which appears as if the mask mark were deformed although the two are overlaid, and the detection accuracy (reliability) of the mask mark would fall.

## Summary of the Invention

The present invention was devised in light of aforementioned circumstances. Thus, a first object is to provide a method of aligning a mask and workpiece in an exposure device which permits the mask and workpiece to be aligned accurately while minimizing the reduction in alignment accuracy of the mask and workpiece should the shape of the alignment marks be deformed or the position relative to set values be shifted.

A second object is to permit alignment in which the required alignment accuracy is ensured by aligning a mask and workpiece after selecting only those alignment marks having high reliability by verifying the reliability of the spatial coordinates of the alignment marks.

Aforementioned problems are resolved by the present invention as follows.

(1) A plurality of proximal workpiece marks having a given relative relationship are affixed so as to lie within the field (within the search range of workpiece marks) of an alignment microscope.

In aligning a mask and workpiece, the spatial coordinates of aforementioned a plurality of workpiece marks are detected, the spatial coordinates which are averaged from said spatial coordinates are determined, and the mask and workpiece are aligned by moving the mask or workpiece so that the mask mark has a prescribed spatial relationship to said averaged spatial coordinates.

(2) The workpiece alignment marks which permit the required alignment accuracy to be ensured in aforementioned (1) are selected from the relative spatial relationship of the spatial coordinates that averaged the spatial coordinates of a plurality of workpiece alignment marks and of each of a plurality of spatial coordinates of workpiece alignment marks. Alignment is then carried out as described in (1) using the mean spatial coordinates of the selected workpiece alignment marks.

(3) Aforementioned technique can be applied to detecting the mask marks of proximity exposure devices or contact exposure devices.

## Brief Description of Drawings

Figure 1 is diagram showing an example of a projection exposure device in accordance with one embodiment of the present invention;

Figures 2a & 2b are diagrams explaining the averaging of the spatial coordinates of workpiece marks;

Figure 3 is a diagram explaining the arrangement of workpiece marks on a circle.

Figures 4(a) to 4(c) are diagrams explaining the $3\sigma 1$ relation between the distribution of the "deviation" in workpiece marks and alignment accuracy;

Figure 5 is a graph showing the relation between the number of averaged workpiece marks and the averaging effect.

Figure 6 is diagram showing an embodiment of a proximity exposure device;

Figure 7 is diagram explaining the appearance of workpiece marks overlapping below mask marks;

Figure 8 is a diagram showing the structure of a conventional alignment microscope;

Figures 9(a)-9(e) are diagrams explaining the conventional pattern search method;

Figure 10 is a diagram showing a conventional example of workpiece marks imaged by an alignment microscope and presented on a monitor;

Figures 11(a) & 11(b) are diagrams showing examples of shapes of known workpiece marks;

Figure 12 is a diagram for explaining a known manner of pattern searching;

Figure 13 is a diagram showing an example of deformation of a workpiece mark due to process defects;

Figures 14(a) & 14(b) are diagrams explaining the effect of workpiece mark deformation in the prior art; and

Figures 15(a) & 15(b) are diagrams explaining the "score" in the case of workpiece mark deformation in the prior art.

## Detailed Description of the Invention

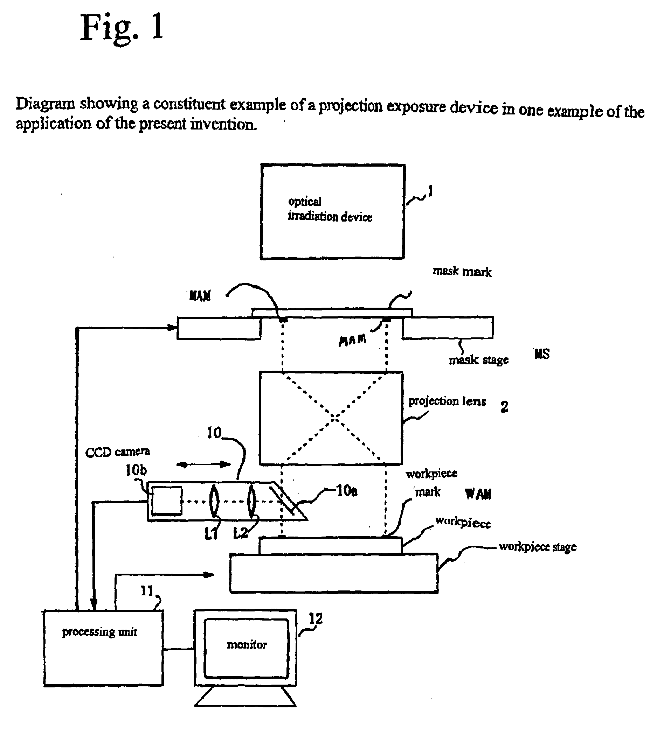

Figure 1 shows the structure of a projection exposure device which is applicable to attainment of the objects of the present invention. This projection exposure device comprises a mask stage MS, upon which is laid at least one mask mark MAM, and a mask M upon which a mask pattern is formed.

Exposure light is emitted from an optical irradiation device 1 and is irradiated upon a workpiece W laid on a workpiece stage WS through mask M and a projection lens 2. The mask pattern formed on mask M is projected onto workpiece W and the mask pattern upon the workpiece W is thereby exposed.

An alignment microscope 10 can move in the directions indicated by the arrows in the diagram and is mounted at each of two sites between projection lens 2 and workpiece W (only one alignment microscope being shown in Figure 1). Alignment microscope 10 is inserted at the position shown in the diagram before the mask pattern formed on mask M is exposed on workpiece W, and mask M is aligned with workpiece W.

As mentioned relative to the prior art above, alignment microscope 10 comprises a half mirror 10a, lens L1, L2 and CCD camera 10b.

Mask M and workpiece W in Figure 1 are aligned as follows:

[1] Alignment light (non-exposure light) is irradiated from optical irradiation device 1, from exposure light or from an alignment light source that is not shown, and the mask mark image formed on mask M is imaged by CCD camera 10b of alignment microscope 10 and is then fed to processing unit 11. Processing unit 11 then converts the mask mark image into spatial coordinates and stores them. Various methods of detecting mask marks are known and the gazette of Japanese Kokai Publication HEI-9-82615 can be consulted for an example.

[2] Pattern searching is then carried out in aforementioned manner and the workpiece mark image on workpiece W is detected. However, instead of one workpiece mark being provided on the workpiece as in a conventional example, a plurality of workpiece marks WAM having the same shape are affixed in proximity on workpiece W so as to lie within one field of an alignment microscope in this embodiment. The processing unit 11 detects the spatial coordinates of the plurality of workpiece marks WAM by aforementioned pattern search. The individual workpiece marks formed on workpiece W are registered in advance.

[3] The processing unit 11 averages the spatial coordinates of a plurality of workpiece mark images that were detected as discussed below, determines the spatial coordinates that constitute the baseline for alignment with mask mark MAM (hereinafter abbreviated average workpiece mark spatial coordinates), moves the workpiece stage WS (or mask stage MS) so that the spatial coordinates of stored mask mark MAM have a prescribed spatial relationship with the average workpiece mark spatial coordinates that were already determined, and thereby completes alignment of mask M and workpiece W. In completing the aforementioned alignment, the reliability of the spatial coordinates of the detected workpiece marks is verified based on the relative spatial relationship between aforementioned average workpiece mark spatial coordinates determined from the spatial coordinates of a plurality of workpiece marks as discussed below and the spatial coordinates of each of a plurality of workpiece marks. Only those workpiece marks whose required alignment accuracy can be ensured are then selected. By so doing, the required alignment accuracy can be ensured. Working examples of the present invention are explained more concretely below.

[1] An example of an arrangement of workpiece marks and a method of calculating the average workpiece mark spatial coordinates:

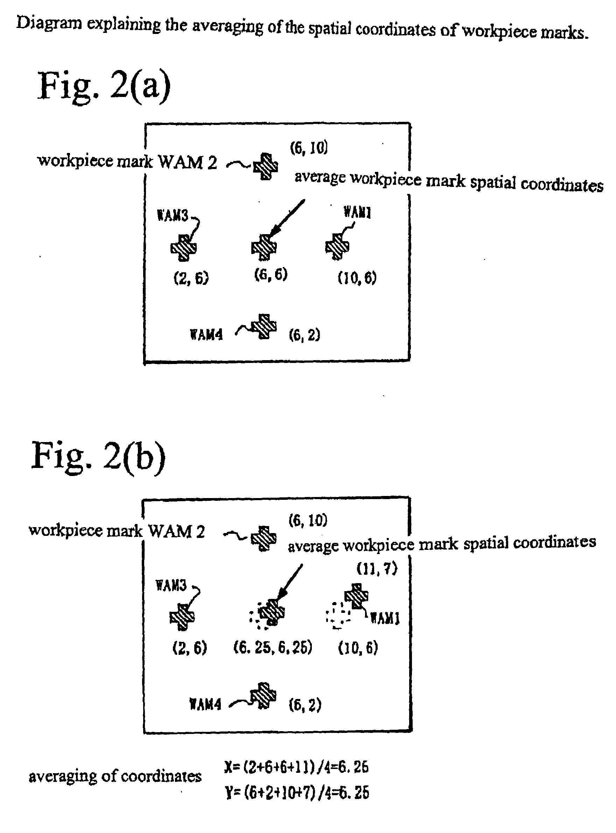

(a) Method of affixing a plurality of workpiece marks, of averaging the spatial coordinates of the workpiece marks and of then determining the average workpiece mark spatial coordinates. For example, four workpiece marks having the same shape, are affixed so as to lie within a given field (search range of workpiece marks) of alignment microscope 10. The position of alignment with the mask marks uses the spatial coordinates which average the spatial coordinates of said four workpiece marks (in the respective X coordinates and Y coordinates). This working example is explained below with reference to Figure 2.

Four workpiece marks WAM1 to WAM4 are designed so as to be affixed at positions (10, 6), (6, 10), (2, 6), (6, 2) in (X, Y) coordinates as shown in Figure 2(a). Workpiece marks are then formed on workpiece W as mentioned above. In fact, the positions of the workpiece marks are shifted by "process defects" as mentioned above, and there are also cases in which they are affixed in accordance with the design values in Figure 2(a).

[2] The image data of the section where workpiece marks WAM1-WAM4 are formed on workpiece W are collected in processing unit 11 (image processing device) by alignment microscope 10 as mentioned above when aligning mask M and workpiece W. The pattern of said image data is searched by processing unit 11, the four spatial coordinates having the highest scores relative to the registered mark are computed and said four spatial coordinates are recognized as the spatial coordinates of each workpiece mark. The respective spatial coordinates are recognized to be (10, 6), (6, 10), (2, 6), (6, 2) as shown in Figure 2(a).

[3] The X coordinates and Y coordinates of the four spatial coordinates of workpiece marks WAM1, WAM2, WAM3, WAM4 are averaged in processing unit 11. In this case, the values of the averaged spatial coordinates are (6, 6) as shown in Figure 2(a). The mask marks are aligned to the coordinate positions (aforementioned average workpiece mark spatial coordinates) determined by this averaging.

In Fig. 2(b) one workpiece mark is assumed to be deformed or displaced, and the recognized position is taken to be deviated from its original position. For example, workpiece mark WAM1 is recognized as having spatial coordinates (11, 7) which represent a position shifted by one unit each in the X coordinates and Y coordinates.

As mentioned above, if a mask were aligned to one workpiece mark by the conventional method and if the recognized position were to shift like workpiece mark WAM1 at the right of said diagram, said spatial deviation (one unit each in the X coordinate and Y coordinate) would affect the alignment accuracy. However, the average workpiece mark spatial coordinates would be (6.25, 6.25) as shown in Figure 2(b) if the spatial coordinates of workpiece marks WAM1, WAM2, WAM3 and WAM4 are averaged. Since the mask is aligned relative to this position, the spatial deviation in the X coordinate and Y coordinate is reduced to 3 of the deviation compared to that when using one workpiece mark.

Similarly, the deterioration in the alignment accuracy due to deviation in the recognized position of the workpiece mark could be further reduced by increasing the number of affixed workpiece marks.

In aforementioned manner, the positioning accuracy can be enhanced compared to the use of one workpiece mark by affixing a plurality of workpiece marks and by then determining the average workpiece mark spatial coordinates through averaging.

In aforementioned working example, the number of workpiece marks may be increased further and the averages of the spatial coordinates of the workpiece marks remaining after excluding spatial recognized workpiece marks with a low score may be determined. The alignment accuracy may be enhanced still further by so doing. Specifically, since workpiece marks with spatial deviation due to process defects can be envisioned to have a low score, workpiece marks posing a high possibility of spatial deviation can be excluded by taking the mean value after eliminating workpiece marks having a low score and the average workpiece mark spatial coordinates can be determined.

In addition, determination of the average workpiece mark spatial coordinates using a plurality of workpiece marks as mentioned above has the following advantages.

For example, when one of a plurality of workpiece marks deviates from the field (search range) of alignment microscope 10 because of problems involving the spatial accuracy which was set or because of problems with positioning accuracy or shutdown of feed during feeding of a workpiece over a workpiece stage or even if process defects become excessive and the workpiece mark peels from the workpiece, the average workpiece mark spatial coordinates can be determined using the remaining workpiece marks that are within the field of alignment microscope 10.

[b] Method of determining the average workpiece mark spatial coordinates using at least three workpiece marks after arranging a plurality of workpiece marks on a circumference

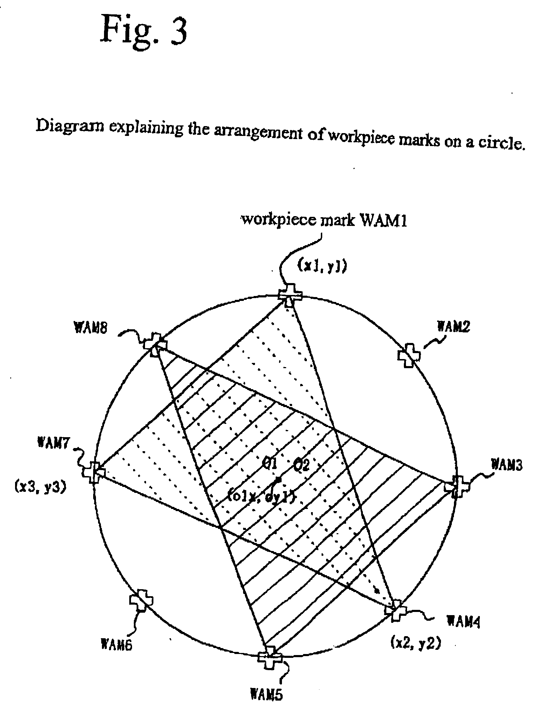

A plurality of workpiece marks is affixed on a given circumference and the three workpiece marks having the highest scores are selected. The center of the circle circumscribed by the three points is computed from their three spatial coordinates and a mask is aligned relative to the spatial coordinates of the center of the circle which was determined. This working example is explained using Figure 3 below.

Figure 3 shows eight workpiece marks WAM1-WAM8 affixed on a circumference. The eight workpiece marks WAM1 - WAM8 are detected by alignment microscope 10 as mentioned above. Three of the detected workpiece marks WAM1-WAM8 are selected, and the center 01 of a circle which circumscribes a triangle formed by said three marks is determined.

The center of the circle circumscribed by said three points is determined by the following expression from the three sets of coordinates, assuming that the center coordinates 01 of a circle through which the three points (x1,y1), (x2,y2), (x3,y3) pass is (o1x, o1y):

$$o1x = \{(y3-y2)(x1x1+y1y1) + (y1-y3)(x2x2+y2y2) + (y2-y1)(x3x3+y3y3)\}/(-L)$$

$$o1y = \{(x3-x2)(x1x1+y1y1) + (x1-x3)(x2x2+y2y2) + (x2-x1)(x3x3+y3y3)\} / (L)$$

Here, L = (x1y2-x1y3+x2y3-x2y1+x3y1-x3y2) • 2

The spatial coordinates (o1x, o1y) of center 01 determined by above computations is the average of the spatial coordinates of three workpiece marks similarly to the coordinate position which was averaged as explained above.

As indicated above, even if the position recognized through the workpiece marks should deviate from the set values, exacerbation of the alignment accuracy can be reduced by determining the spatial coordinates of center 01 from the spatial coordinates of three workpiece marks.

Similarly, a different combination of three workpiece marks can be selected and the center 02 of a circle which circumscribes a triangle formed by this combination of three marks can be determined similarly to the manner discussed above, and likewise the centers of circles which circumscribe third and fourth triangles of differing combinations of three workpiece marks can be calculated in the same manner.

If the workpiece marks are formed in accordance with the set values, the alignment accuracy could be enhanced further as in the first case above by further averaging of these spatial coordinates since the positions of aforementioned 01, 02 ... would match.

Also, just as before, the averages of the spatial coordinates of the workpiece marks remaining after excluding those with low scores from among the workpiece marks which were detected may be determined in this working example as well. The alignment accuracy can be enhanced further by so doing.

Furthermore, the following advantages are realized just as in the first example by determining the average workpiece mark spatial coordinates using a plurality of workpiece marks as mentioned above. For example, when one of the eight workpiece marks in Figure 3 deviates from the field (search range) of the alignment microscope because of problems involving the spatial accuracy which was set or when the workpiece mark peels from the workpiece because of excessive process defects, the average workpiece mark spatial coordinates can be determined using the remaining workpiece marks which can be utilized.

Additionally, this embodiment can accommodate flexibility if any workpiece marks are lost or if part of a group of workpiece marks should fall outside of the field of the alignment microscope since a plurality of coordinates of the center of a circumscribed circle can be determined by altering the combination of three workpiece marks.

[2] Verification of workpiece mark spatial coordinates and selection of workpiece alignment marks which can ensure the required alignment accuracy

When a plurality of workpiece marks are affixed as mentioned above, process evaluation of the preceding procedures can be carried out as follows in addition to reducing exacerbation of the alignment accuracy.

The distance between workpiece marks is known from the set values. In addition, since the spatial coordinates of workpiece marks which are actually affixed can be determined, the distance between them can be calculated, Accordingly, anomalies in distances between workpiece marks can be detected by comparing the distance between workpiece marks which were affixed on each workpiece and the set values. Any process deficiencies in the preceding procedure which lead to anomalies in the workpiece mark position can be detected and the production process of the preceding procedure can be revised. The production of rejects in later procedures can be prevented as a result.

In addition, workpiece marks which allow the required alignment accuracy to be ensured can be selected as follows.

The method of selecting workpiece marks which enable aforementioned alignment accuracy to be ensured is explained below.

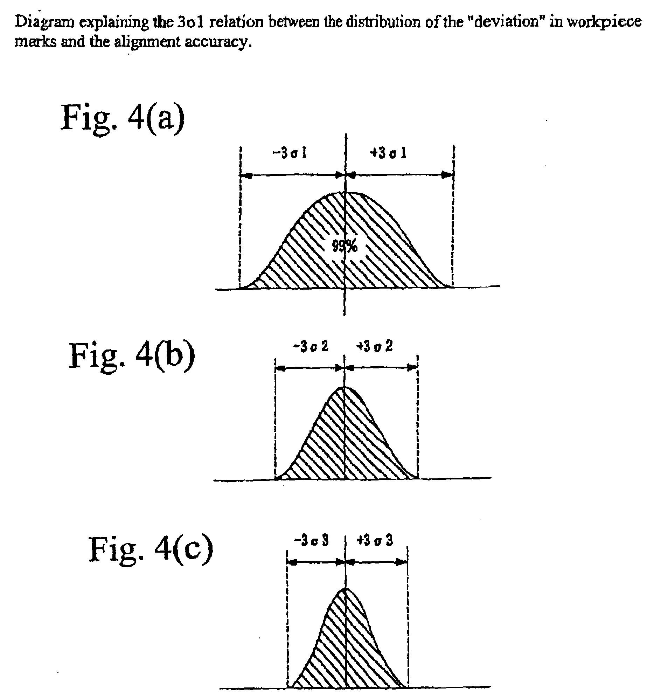

The position of the workpiece marks is assumed to be dispersed with a regular distribution relative to the original position (set position). Assuming the standard deviation to be $\sigma1$ when they have an ideal regular distribution as shown in Figure 4(a), each datum would lie within the range of $\pm 3\sigma1$ at a probability above 99%. Specifically, even if the spatial coordinates of a workpiece mark should deviate from the original position, there is a probability above 99% that the maximum value of that deviation would be within $3\sigma1$ (here, 3 $\sigma$ 1 denotes the workpiece mark accuracy). Accordingly, when the standard deviation of the spatial coordinates of a workpiece mark is $\sigma1$, alignment with this workpiece mark would be $\pm A$ at a probability above 99%, which would match aforementioned workpiece mark accuracy of $\pm 3 \sigma 1$ (here, we assume that the alignment accuracy depends only on the spatial accuracy of the workpiece mark). Specifically, when the standard deviation of a single workpiece mark is $\sigma1$, the required alignment accuracy of $\pm A$ cannot be attained if [required alignment accuracy: $\pm A$] is smaller than [workpiece mark accuracy: $\pm 3 \sigma1$].

However, even if the workpiece mark accuracy which was set is $\pm3 \sigma1$, the amount of deviation in the aforementioned average workpiece mark spatial coordinates determined by averaging a plurality of workpiece marks can be reduced as noted above. For this reason, the alignment accuracy is enhanced by alignment to the average workpiece mark spatial coordinates obtained by aforementioned averaging. For example, any two pieces of data would be picked from N number of data groups (for example, the data group shown in Figure 4(a)) having standard deviation of $\sigma1$ and averaged. By so doing, the distribution would be narrower than Figure 4(a) as shown in Figure 4(b) assuming a new data group to be constructed from the data determined following averaging. For example, the standard deviation would be $\sigma2 \doteqdot 0.7 \sigma1$.

Furthermore, the distribution of data determined by averaging any three pieces of data picked from the data group in Figure 4(a) would be still narrower than Figure 4(b) as shown in Figure 4(c), just as above. For example, the standard deviation would be $\sigma3 = 0.6 \sigma1$. The diminution of the standard deviation by averaging data in this manner represents an effect of averaging.

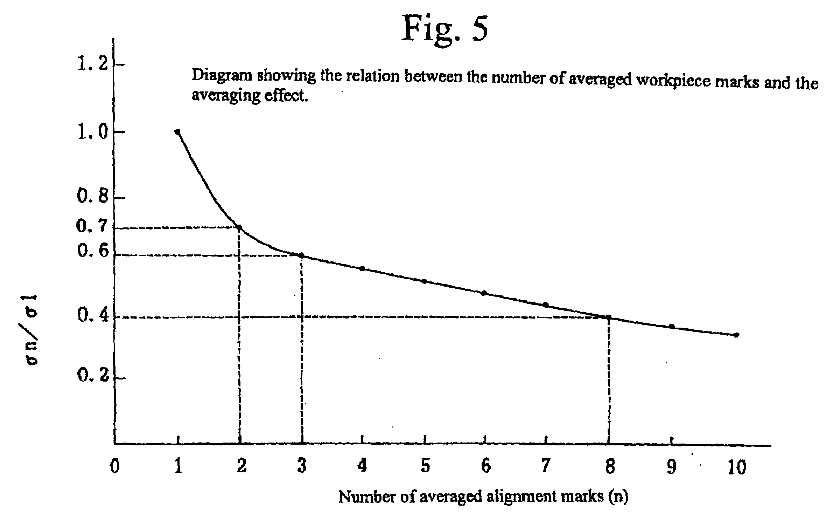

Figure 5 is a diagram showing one example of the relation between the number of averaged workpiece marks and the averaging effect. The abscissa represents the number of workpiece marks while the ordinate represents the value obtained after dividing the standard deviation $\sigma n$ of the data group which averaged n number of workpiece marks by $\sigma1$, the standard deviation of the original data group, that is, $\sigma n/\sigma1$.

Figure 5 itself presents a calculation of the averaging effect using a suitably generated random number table as the original data group. According to Figure 5, if the spatial coordinates of two workpiece marks (standard deviation $\sigma1$) are averaged, the standard deviation $\sigma2$ of the averages of the spatial coordinates of two workpiece marks would be about 0.7 $\sigma1$ due to aforementioned averaging effect. Specifically, even if the original standard deviation of the workpiece marks is $\sigma1$, the alignment accuracy $\pm A$ could reach 3 x (0.7 $\sigma1$) = 2, 1 $\sigma1$ by alignment using the average spatial coordinates of two workpiece marks. Furthermore, the standard deviation $\sigma3$ would be appropriately $0.6\sigma1$ if the spatial coordinates of three workpiece marks are averaged.

Workpiece marks which ensure the alignment accuracy are selected in this working example based on the above.

[1] Workpiece marks are created as a plurality of samples and the amount of deviation relative to the original position (set position) is measured. The amount of deviation is measured when creating workpiece marks from said deviation, and the deviation in the spatial coordinates of the workpiece marks when creating workpiece marks from said deviation, specifically, aforementioned standard deviation $\sigma1$, is determined.

[2] The method of averaging a plurality of workpiece marks (expression which determines a plurality of average workpiece mark spatial coordinates) is set, and a graph of the averaging effect is completed as in Figure 5.

The shape of the graph shown in Figure 5 is determined as a function of the expression which determines the average workpiece mark spatial coordinates. Accordingly, a graph as shown in Figure 5 must be created as a function of the expression which determines aforementioned average workpiece mark spatial coordinates.

[3] Whether or not the required alignment accuracy: $\pm A$ can be attained by averaging using numerous workpiece marks based on aforementioned graph of the averaging effect which was determined and on required alignment accuracy: $\pm A$ is determined.

Assuming that the required alignment accuracy: $\pm A$ can be attained by averaging one workpiece mark, the average workpiece mark spatial coordinates would be computed from the spatial coordinates of $n1$ or more workpiece marks if $n1$ or more workpiece marks could be detected within the field of the alignment microscope, and alignment to said averaged spatial coordinates would be completed.

The number of averaged workpiece marks can be determined as follows.

The average number of workpiece marks can be determined for reaching the required alignment accuracy = $\pm 1.2$ μm when the original standard deviation of workpiece marks is $\sigma1$ equals 1 μm, for example.

i) First, the standard deviation $\sigma n$ of workpiece marks in which required alignment accuracy: $\pm A$ can be ensured is determined. Here, $\sigma n$ represents the standard deviation determined by averaging n number of workpiece marks as mentioned above. In this case, the standard deviation σn is 3 x σn = 1.2, specifically, σn = 1.2/3 since the required alignment accuracy is 1.2.

Next, the value of X which satisfies X = σn/ σ1 is determined. X (=σn/ σ1) corresponds to the ordinate in Figure 5. In the case of this example, the standard deviation σ1 of the original workpiece marks is σ1 = 1 μm and X = σn/ σ1 = 1.2/3 = 0.4 since the standard deviation an determined by averaging n number of workpiece marks must be under 1.2/3.

ii) The number of averaged workpiece marks is determined using the graph of the averaging effect created in [2] above. For example, eight or more workpiece marks may be averaged to reach a required alignment accuracy ≤± 1.2 μm since the number of averaged workpiece marks would be eight if X (σn/ σ1) = 0.4 , assuming that a graph of the average created in [2] has the shape shown in Figure 5.

Here, since the arrangement of aforementioned workpiece marks is known from the set values, the distance between each workpiece mark and the average workpiece mark spatial coordinates (spatial coordinates which form the baseline in alignment) after averaging the spatial coordinates of workpiece marks having set values is known.

Thus, the amount of deviation between the distance between the spatial coordinates of each workpiece mark which was detected and the average workpiece marks versus the distance between the spatial coordinates of the original workpiece marks and the average spatial coordinates is computed. Any spatial coordinates of workpiece marks in which the amount of deviation exceeds a given level are dropped from averaging. By so doing, obstruction of the averaging effect due to mistaken recognition of dirt, for example, adhering to a workpiece as a workpiece mark can be prevented. Depending on the extent of aforementioned deviation, the question of whether or not samples are excluded from averaging would be suitably set in light of the variations in the samples of workpiece marks which were created.

Even if workpiece marks having aforementioned great deviation (or workpiece marks mistakenly recognized as having great deviation) are excluded, if numerous workpiece marks whose required alignment accuracy could be reached should remain, the average spatial coordinates could be determined from those remaining workpiece marks and alignment could be completed.

If the required alignment accuracy cannot be attained by averaging remaining workpiece marks after excluding workpiece marks having great deviation, alignment would be discontinued.

(3) Other applicable examples

(a) Application of mask marks in proximity exposure device and contact exposure device.

The alignment of a workpiece and mask using a plurality of workpiece marks was explained above, but this can be applied to proximity exposure devices and contact exposure devices as well.

As mentioned above, if the pattern of a workpiece mark under a mask mark should appear when observing mask marks in proximity exposure devices and contact exposure devices using an alignment microscope, it is detected by a shape which appears as if the mask mark were deformed although the two are overlaid, and aforementioned detection accuracy (reliability) of the mask mark would fall.

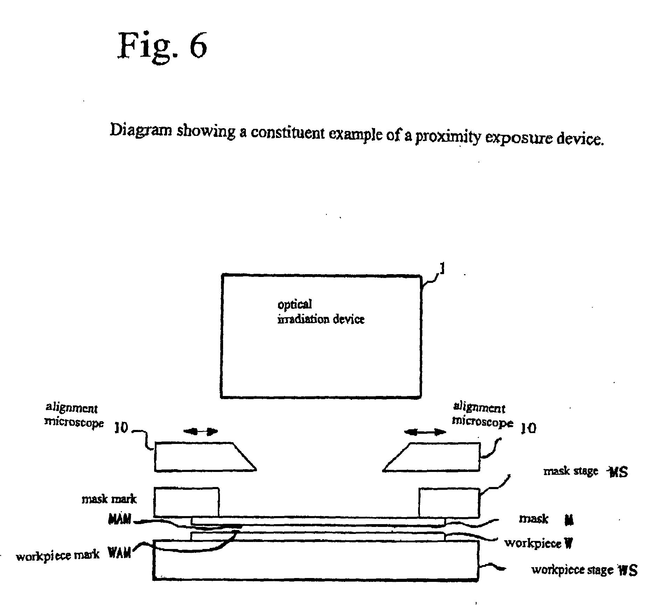

This is explained below using the proximity exposure device shown in Figure 6 as an example.

In the diagram, MS represents the mask stage upon which are laid mask marks MAM and mask M on which is formed a mask pattern. Furthermore, WS represents the workpiece stage upon which is laid a workpiece on which is formed workpiece mark WAM.

Exposure light is emitted from optical irradiation device 1 and is irradiated on the workpiece W on workpiece stage WS through mask M. The mask pattern that is formed on mask M is then projected onto workpiece W and a mask pattern is thus exposed on workpiece W.

Alignment microscope 10 that can move in the direction of the arrows in the diagram is mounted over mask M and alignment microscope 10 is inserted at the position shown in the diagram before the mask pattern formed on mask M is exposed on workpiece W. Mask M is then aligned with workpiece W.

Alignment microscope 10 is comprised of a half mirror, lens and CCD camera, etc., as shown in aforementioned Figure 8.

Alignment of mask M with workpiece W in Figure 6 is completed in the following manner.

[1] Workpiece stage WS is elevated and mask M is brought into contact with workpiece W. After the inclination of mask M is matched with that of workpiece W, workpiece stage WS is lowered slightly. By so doing, mask M and workpiece W are set so as to have a parallel and constant separation.

[2] Alignment microscope 10 is inserted at the position shown in Fig. 8 and the mask marks MAM as well as the workpiece marks are observed. Next, workpiece stage WS is moved so that mask marks MAM and workpiece marks WAM coincide.

When observing the mask marks MAM and workpiece marks WAM via alignment microscope 10 in aforementioned procedure [2], the mask mark image and the pattern of workpiece marks WAM, etc., on workpiece W are both imaged by alignment microscope 10 when mask M is brought into proximity of workpiece W. Accordingly, the shape of the mask mark MAM may appear to change depending on the surface state of workpiece W. This can lower the detection accuracy of mask mark MAM as well as the alignment accuracy.

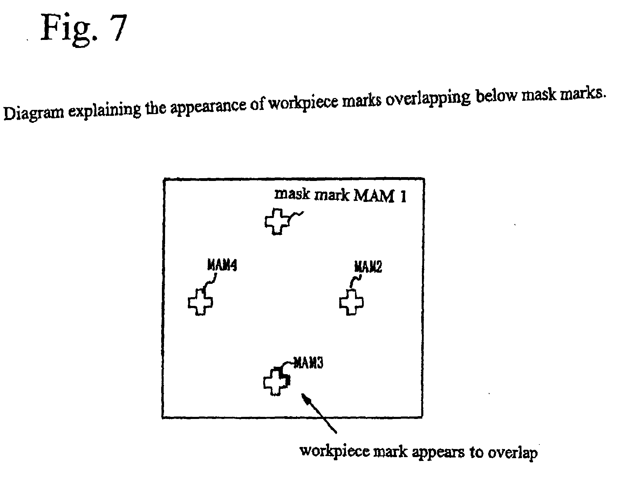

Aforementioned problem can be resolved by applying the technique of arrangement of aforementioned multiple alignment marks to mask marks. Specifically, mask marks MAM1 - MAM4 are arranged so as to enter one field of the alignment microscope as shown in Figure 7. The score of detected mask marks MAM1 to MAM4 is determined as indicated above, and alignment is carried out using the mask marks which remain after eliminating those with a low score. By so doing, even if changes in the overlapping shape of workpiece mark WAM under mask mark MAM are visible, as shown in Figure 7 (mask mark MAM 3 in Figure 7), such mask mark MAM 3 can be removed to carry out alignment, and the alignment accuracy can be raised.

A plurality of workpiece marks WAM are affixed on workpiece W corresponding to mask marks MAM 1-4. Mask M and workpiece M may be aligned so that the average spatial coordinates of both would coincide, or one workpiece mark WAM could be affixed on the workpiece W and the positions of a plurality of mask marks MAM 1-4 may be averaged. The mask mark average spatial coordinates which would form the baseline for alignment, the aforementioned workpiece mark WAM could be determined and mask M could be aligned with workpiece W so that said mask mark average spatial coordinates coincide with the workpiece mark WAM.

(b) Application to via hole in printed circuit board using laser processing

The above mentioned working example explained a case in which workpiece marks are affixed by exposure, can be utilized for the case where via hole patterns for wiring in the production of printed circuit boards, etc., are used as workpiece marks

Via holes are created by processing using laser light, for example. The diameter of via holes is usually 150 to 200 μm. In addition, the processing spatial accuracy using laser processing is about ± 20 μm at present. In that range, the position of workpiece marks (via holes in this case) varies.

Thus, a plurality of via holes are created as workpiece marks. The average spatial coordinates are determined from the spatial coordinates of a plurality of via holes as mentioned above, and the printed circuit board is aligned using such average spatial coordinates as the baseline. Decline in the alignment accuracy due to variation in the processing spatial accuracy of via holes can be avoided by so doing.

**Effects of Invention**

The following effects can be attained in the present invention as explained above.

(1) Even if deviation in the recognized position of the workpiece mark should arise due to workpiece mark deformation or spatial deviation, exacerbation of the alignment accuracy of the mask and workpiece due to said deviation can be reduced since a plurality of workpiece marks are affixed and a mask is aligned to the spatial coordinates which averages the individual spatial coordinates.

Furthermore, a mask and workpiece can be aligned even if some of a series of workpiece mark groups should lie outside of the field (search range) of an alignment microscope or if some workpiece marks are lost.

In particular, the present invention can provide flexibility, if any workpiece marks are lost or if part of a group of workpiece marks should fall outside of the field of the alignment microscope, since the center of a circumscribed circle can be determined by any three workpiece marks that were selected once a plurality of workpiece marks are affixed on a given circle and a mask is aligned to the central position of said circle.

(2) The development of deficiencies in a process which would lead to abnormalities in the position of workpiece marks in a preceding procedure can be discovered by comparing the distance between workpiece marks that were computed based on spatial coordinates that were detected and the distance between workpiece marks having set values.

Alignment in which the required alignment accuracy is secured can be carried out since workpiece alignment marks that enable the required alignment accuracy to be ensured can be selected from the relative spatial relation between spatial coordinates that average the spatial coordinates of a plurality of workpiece alignment marks and the spatial coordinates of each of a plurality of workpiece alignment marks.

(3) The detection accuracy of the spatial coordinates of a mask mark can be enhanced by applying the technique of the present invention to mask marks in proximity exposure devices and contact exposure devices. Furthermore, the alignment accuracy of printed circuit boards can be enhanced using via holes as workpiece marks by applying this technique to the completion of via holes on printed circuit boards.

**Claims**

1.  A method of aligning mask and workpiece in an exposure device in which a mask to which a mask alignment mark is affixed is aligned with a workpiece to which a plurality of workpiece alignment marks corresponding to aforementioned mask are affixed, the workpiece alignment marks being affixed in proximity so as to lie within one field of an alignment microscope, wherein

    the spatial coordinates of a plurality of workpiece alignment marks are detected within the field of an alignment microscope, and are aligned so that the spatial coordinates of the mask alignment marks have a prescribed spatial relationship relative to the mean spatial coordinates determined from said spatial coordinates of the plurality of workpiece alignment marks.

2.  The method of aligning mask and workpiece in an exposure device of Claim 1 in which, before mask and workpiece are aligned, workpiece alignment marks which permit the required alignment accuracy to be ensured are selected from the relative spatial relationship of the spatial coordinates which averaged the spatial coordinates of a plurality of workpiece alignment marks and the spatial coordinates of each of a plurality of workpiece alignment marks, and alignment is done using the mean spatial coordinates of the selected workpiece alignment marks.

3.  A method of aligning mask and workpiece in a proximity or contact exposure device in which a mask to which a plurality of mask alignment marks are affixed in proximity so as to lie within one field of an alignment microscope

    is aligned with a workpiece to which workpiece alignment marks are affixed, wherein the spatial coordinates of a plurality of mask alignment marks are detected within the field of an alignment microscope,
    and are aligned so that the mask and workpiece have a prescribed spatial relationship based on the spatial coordinates of aforementioned a plurality of mask alignment marks and the spatial coordinates of aforementioned workpiece alignment marks.

# Fig. 1

Diagram showing a constituent example of a projection exposure device in one example of the application of the present invention.

optical irradiation device ~1

mask mark

MAM

MAM

mask stage MS

projection lens 2

CCD camera

10b

10

10a

workpiece mark WAM

L1 L2

workpiece

workpiece stage

11

processing unit

12

monitor

Diagram explaining the averaging of the spatial coordinates of workpiece marks.

# Fig. 2(a)

workpiece mark WAM 2 ⟶ (6, 10)

average workpiece mark spatial coordinates

WAM3 ⟶

WAM1

(2, 6)     (6, 6)     (10, 6)

WAM4 ⟶ (6, 2)

# Fig. 2(b)

workpiece mark WAM 2 ⟶ (6, 10)

average workpiece mark spatial coordinates

(11, 7)

WAM3 ⟶

WAM1

(2, 6)     (6. 25, 6. 25)     (10, 6)

WAM4 ⟶ (6, 2)

averaging of coordinates

$X = (2+6+6+11)/4 = 6.25$
$Y = (6+2+10+7)/4 = 6.25$

# Fig. 3

Diagram explaining the arrangement of workpiece marks on a circle.

Diagram explaining the $3\sigma1$ relation between the distribution of the "deviation" in workpiece marks and the alignment accuracy.

## Fig. 4(a)

$-3\sigma1$ $+3\sigma1$

99%

## Fig. 4(b)

$-3\sigma2$ $+3\sigma2$

## Fig. 4(c)

$-3\sigma3$ $+3\sigma3$

## Fig. 5

Diagram showing the relation between the number of averaged workpiece marks and the averaging effect.

# Fig. 6

Diagram showing a constituent example of a proximity exposure device.

# Fig. 7

Diagram explaining the appearance of workpiece marks overlapping below mask marks.

workpiece mark appears to overlap

# Fig. 8
# (Prior Art)

Diagram showing the diagrammatic structure of an alignment microscope.

Illuminating light

alignment
microscope   10

10b

CCD
camera

half mirror   10a

workpiece · W

L1   L2

11   12

processing
unit

monitor

workpiece mark   WAM

Diagram explaining the conventional pattern search method.

Fig 9(a) alignment marks
(Prior Art)

Fig. 9(c) detected pattern A
(Prior Art)

Fig. 9(b) registered pattern
(Prior Art)

Fig. 9(d)
(Prior Art)

detected pattern B

Fig. 9(e)
(Prior Art)

detected pattern C

# Fig. 10
# (Prior Art)

Diagram showing one example of workpiece marks imaged by an alignment microscope and presented on a monitor.

Fig. 11(a)
(Prior Art)

Fig. 11(b)
(Prior Art)

Diagram showing an example of the shape of workpiece marks.

# Fig. 12
# (Prior Art)

Diagram for explaining pattern search.

# Fig. 13
# (Prior Art)

Diagram showing an example of deformation of a workpiece mark due to process defects.

workpiece mark WAM                    Jut out

Omitted

Diagram explaining the state of workpiece mark deformation.

## Fig. 14(a)
## (Prior Art )

center of
workpiece mark

number of
pixels 45

★

## Fig. 14(b)
## (Prior Art)

Original workpiece mark

Deformed workpiece mark

☆

Center of original workpiece mark

## Fig. 15(a)
## (Prior Art)

Diagram explaining the score in the case of workpiece mark deformation.

Original workpiece mark

Deformed workpiece mark

Center of original
workpiece mark

Score 35/45=0.78

Center of deformed workpiece mark

## Fig. 15(b)
## (Prior Art)

Original
workpiece mark

Deformed workpiece mark

Center of original
workpiece mark

Score 38/45=0.84

Center of deformed
workpiece mark